# EUROPÄISCHE PATENTSCHRIFT

(11) **EP 2 915 192 B1**
(45) Veröffentlichungstag und Bekanntmachung des Hinweises auf die Patenterteilung: **24.08.2022**
(21) Anmeldenummer: 13770878.0
(22) Anmeldetag: 25.09.2013
(51) Int. Cl.: H01L 25/16, H01L 33/48, H01L 33/00

(54) **LEUCHTDIODENANODRNUNG, MODUL UND VERFAHREN ZUR HERSTELLUNG EINER LEUCHTDIODENANORDNUNG**
LIGHT-EMITTING DIODE ARRANGEMENT, MODULE, AND METHOD FOR PRODUCING A LIGHT-EMITTING DIODE ARRANGEMENT
SYSTÈME DE DIODE ÉLECTROLUMINESCENTE, MODULE ET PROCÉDÉ DE FABRICATION D'UN SYSTÈME DE DIODE ÉLECTROLUMINESCENTE

(30) Priorität: 30.10.2012 DE 102012110397
(43) Veröffentlichungstag der Anmeldung: 09.09.2015
(73) Patentinhaber: TDK Electronics AG, 81671 München (DE)
(72) Erfinder: FAISTAUER, Christian, A-8523 Frauental (AT); HATZL, Stefan Leopold, 8493 Klöch (AT); BRUNNER, Sebastian, A-8042 Graz (AT)
(74) Vertreter: Epping - Hermann - Fischer
(86) Internationale Anmeldenummer: PCT/EP2013/069944
(87) Internationale Veröffentlichungsnummer: WO 2014/067717

(56) Entgegenhaltungen:
- WO-A1-2011/108227
- DE-A1-102008 033 176
- DE-A1-102009 051 866
- US-A1- 2010 078 668
- US-A1- 2011 248 836

## Beschreibung

Es wird eine Leuchtdiodenanordnung aufweisend eine Leuchtdiode (LED), insbesondere ein Leuchtdiodenchip, angegeben. Derartige LEDs sollen im Automobilbereich, beispielsweise im Frontscheinwerfer, eingesetzt werden. LEDs haben durch Streuungen im Fertigungsprozess oftmals unterschiedliche Charakteristiken bezüglich Lichtausbeute und Farbe bei identischen Ansteuerungsströmen. Derartige Schwankungen sind unerwünscht.

Die Druckschriften US 2011/248836 A1, WO 2011/108227 A1 und US 2010/078668 A1 beschreiben jeweils eine Leuchtdiodenanordnung. Die Druckschrift DE 10 2008 033176 A1 beschreibt eine Leuchtdiodenanordnung, bei der eine Leuchtdiode und ein Widerstandsnetzwerk zur Charakterisierung der Leuchtdiode auf einem gemeinsamen Schaltungsträger angeordnet sind. Die Druckschrift DE 10 2009 051866 A1 zeigt eine Leuchtdiodenanordnung nach der Präambel des Anspruchs 1.

Es ist eine Aufgabe, eine Leuchtdiodenanordnung, ein Modul und ein Verfahren zur Herstellung einer Leuchtdiodenanordnung mit verbesserten Eigenschaften anzugeben.

Es wird eine Leuchtdiodenanordnung angegeben. Die Leuchtdiodenanordnung weist eine Leuchtdiode (LED), insbesondere einen Leuchtdiodenchip, auf. Zudem weist die Leuchtdiodenanordnung einen Kodierwiderstand zur Kodierung der Leuchtdiode auf.

Vorzugsweise erfolgt die Kodierung der LED bevor die LED verbaut wird. Insbesondere erfolgt die Kodierung auf einem Substrat, d.h. auf Waferlevel.

Beispielsweise kodiert der Kodierwiderstand eine Charakteristik der LED, z. B. die Lichtausbeute und Farbe der LED, bei einem bestimmten Stromfluss. Somit kann durch Bestimmung des Widerstandswertes für den Kodierwiderstand auf die Charakteristik der LED geschlossen werden. Dadurch wird eine Ansteuerung der LED entsprechend ihrer spezifischen Charakteristik ermöglicht, so dass beispielsweise beim Einsatz mehrerer LEDs mit unterschiedlichen Charakteristiken eine einheitliche Lichtausbeute erreicht werden kann.

Zur Kodierung wird vorzugsweise die Charakteristik der LED bestimmt. Die LED kann dementsprechend in eine Klasse eingeteilt werden. Dies wird auch als "Binning" (Klasseneinteilung) bezeichnet. Jeder Klasse kann ein Widerstandswert des Kodierwiderstands zugeordnet sein. Der Widerstandswert des Kodierwiderstands wird entsprechend der Klasse gewählt, insbesondere eingestellt. Somit ist der Einbauplatz zugehörig zur LED kodiert.

Beispielsweise weist die Leuchtdiodenanordnung einen Träger auf. Die LED ist vorzugsweise auf dem Träger, insbesondere auf einer Oberseite des Trägers, angeordnet. Die LED ist vorzugsweise kodiert, bevor die LED zusammen mit ihrem Träger verbaut wird.

Beispielsweise kann der Träger ein keramisches oder ein organisches Material aufweisen. Beispielsweise weist der Grundkörper mindestens eines der Materialien aus Aluminiumoxid oder Aluminiumnitrid oder eine Keramik des Typs LTCC ("low temperature cofired ceramics", d.h., bei niedriger Temperatur gemeinsam gesinterte Keramik) oder HTCC ("high temperature cofired ceramics"", d.h., bei hoher Temperatur gemeinsam gesinterte Keramik) auf oder besteht aus einem dieser Materialien. Der Träger kann als Leiterplatte, auf Englisch "printed circuit board", ausgebildet sein. Beispielsweise ist der Träger in Vielschichtbauweise ausgebildet.

Der Kodierwiderstand ist erfindungsgemäß zumindest teilweise im Träger vergraben.

Der Kodierwiderstand weist mehrere Widerstände, insbesondere ein diskretes Widerstandselement, auf. Der Widerstand kann beispielsweise in Dünnschicht- oder Dickschichttechnologie ausgebildet sein. Die Widerstände sind zur Bildung des Kodierwiderstandes miteinander elektrisch verschaltet.

Wenigstens einer der Widerstände ist im Träger vergraben. Auf diese Weise kann auf der Oberfläche des Trägers Platz gespart werden. Insbesondere bleibt die Oberfläche frei für die Gestaltung der Optik oder für andere Bauteile wie ESD-Schutz oder NTC, wobei "ESD" für "electrostatic discharge" (elektrostatische Entladung) und "NTC" für "negative temperature coefficient" (negativer Temperaturkoeffizient) steht. Weiterhin kann durch das Vergraben ein Schutz des Widerstands erzielt werden. Ein vergrabener Widerstand ist insbesondere bei einem vielschichtigen Träger, beispielsweise bei einer Mehrlagenkeramik, möglich.

Die Kodierung des Kodierwiderstandes entsprechend der LED kann analog oder digital ausgeführt sein. Es kommt auch eine Mischung aus analoger und digitaler Kodierung in Betracht. Die Art der Kodierung wird entsprechend der Anforderung an Binningklassen gewählt. Die Anzahl der Binningklassen richtet sich nach der jeweiligen Applikation.

Der Kodierwiderstand weist wenigstens eine elektrische Zuleitung, vorzugsweise mehrere elektrische Zuleitungen, auf. Insbesondere kann der Kodierwiderstand mehrere Widerstände aufweisen, wobei jeder Widerstand eine Zuleitung aufweist. Die Kodierung des Kodierwiderstands wird durch die Vornahme einer Unterbrechung oder die Nicht-Vornahme einer Unterbrechung der Zuleitung ausgeführt. Beispielsweise erfolgt die Kodierung mittels Lasertrimmen der Zuleitungen. Bei mehreren Zuleitungen ergeben sich aus den möglichen Kombinationen von unterbrochenen und nicht-unterbrochenen Zuleitungen die möglichen Kodierklassen. Vorzugsweise wird dabei durch eine geeignete Wahl von unterbrochenen und nicht-unterbrochenen Zuleitungen ein Widerstandswert für den Kodierwiderstand, der die LED kodiert, eingestellt. Diese Ausführungsform ist ein Beispiel für eine digitale Kodierung.

In einer vorliegend nicht beanspruchten Ausführungsform erfolgt eine Kodierung durch Trimmen des Kodierwiderstandes. Insbesondere kann der Kodierwiderstand wenigstens einen Widerstand aufweisen, der durch Trimmen kodiert wird. Der Widerstand ist beispielsweise in Dickschichttechnologie hergestellt. Beim Trimmen erfolgt die Einstellung des Widerstandswerts vorzugsweise durch Materialabtrag, insbesondere durch ein Anschneiden des Widerstands. Dabei kann eine Erhöhung des Widerstandswertes erzeugt werden. Diese Ausführungsform ermöglicht eine analoge Kodierung.

Das Trimmen eignet sich beispielsweise für einen Widerstand, der auf einer Außenseite des Trägers angeordnet ist.

Allerdings können auch Widerstände im Inneren mit einer speziellen Technologie getrimmt werden.

In einer Ausführungsform kann der Kodierwiderstand wenigstens einen Widerstand aufweisen, der zur Messung einer Temperatur ausgebildet ist. Beispielsweise weist der Widerstand einen Temperaturkoeffizienten, vorzugsweise einen positiven Temperaturkoeffizienten auf. Dies ermöglicht eine intelligente Ansteuerung, z. B. der LED.

Gemäß einem weiteren Aspekt der Erfindung wird ein Modul angegeben, das mehrere derartige Leuchtdiodenanordnungen aufweist. Vorzugsweise weist das Modul einen weiteren Träger auf, auf dem die Leuchtdiodenanordnungen angeordnet sind. In einem derartigen Modul ist vorzugsweise für jede LED ein Kodierwiderstand vorgesehen, der die LED charakterisiert.

Im Betrieb des Moduls wird vorzugsweise für jede LED der Widerstandswert des zugeordneten Kodierwiderstandes ausgemessen. Entsprechend dem Widerstandswert wird die LED angesteuert. Auf diese Weise kann eine einheitliche Abstrahlcharakteristik des Moduls bei LEDs unterschiedlicher Klassen erreicht werden.

Gemäß einem weiteren Aspekt der Erfindung wird ein Verfahren zur Herstellung einer Leuchtdiodenanordnung angegeben. Dabei wird eine Leuchtdiode und ein Kodierwiderstand zur Kodierung der Leuchtdiode bereitgestellt. Die Leuchtdiode ist vorzugsweise auf einem Träger angeordnet. Der Träger weist vorzugsweise den Kodierwiderstand auf. Insbesondere kann der Kodierwiderstand zumindest teilweise in dem Träger vergraben und/oder zumindest teilweise auf dem Träger angeordnet sein. Es wird eine Charakteristik der Leuchtdiode, beispielsweise eine optische oder elektrische Charakteristik ermittelt. Die Charakteristik kann insbesondere die Lichtausbeute oder die Farbe der LED betreffen. Der Kodierwiderstand wird abhängig von der ermittelten Charakteristik kodiert. Insbesondere kann zur Kodierung der Widerstandswert des Kodierwiderstandes eingestellt werden.

Vorzugsweise wird durch das beschriebene Verfahren die oben beschriebene Leuchtdiodenanordnung hergestellt, so dass alle funktionellen und strukturellen Eigenschaften der Leuchtdiodenanordnung entsprechend im Verfahren bereitgestellt werden können.

Vorzugsweise wird die Leuchtdiode vor der Kodierung des Kodierwiderstandes auf dem Träger angeordnet. Insbesondere kann die Leuchtdiode vor Ermittlung ihrer Charakteristik auf dem Träger angeordnet werden.

Im Folgenden werden die hier beschriebenen Gegenstände anhand von schematischen und nicht maßstabsgetreuen Ausführungsbeispielen näher erläutert.

Es zeigen:
- Figur 1: ein schematisches Schaltbild einer Leuchtdiodenanordnung,
- Figur 2: ein schematisches Schaltbild eines Kodierwiderstands,
- Figur 3: in einer schematischen perspektivischen Ansicht eine Leuchtdiodenanordnung.

Vorzugsweise verweisen in den folgenden Figuren gleiche Bezugszeichen auf funktionell oder strukturell entsprechende Teile der verschiedenen Ausführungsformen.

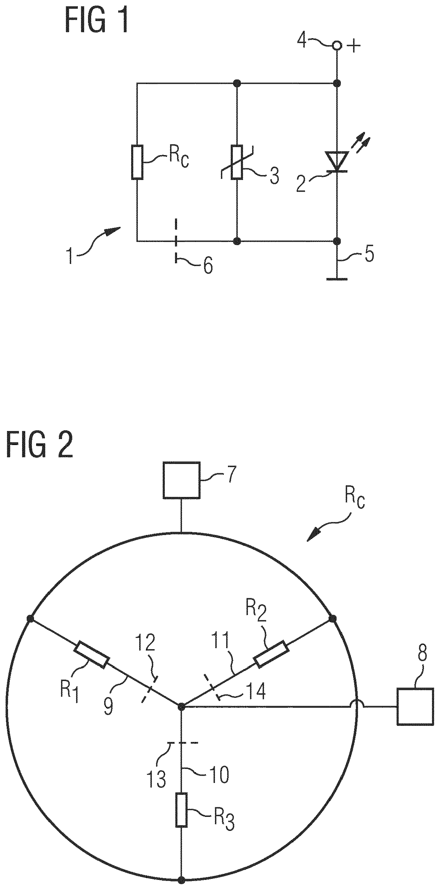

Figur 1 zeigt ein schematisches Schaltbild einer Leuchtdiodenanordnung 1. Die Leuchtdiodenanordnung umfasst eine Leuchtdiode (LED) 2, insbesondere einen Leuchtdiodenchip, und einen Kodierwiderstand R_{C}. Der Kodierwiderstand R_{C} ist parallel zur LED 2 verschaltet. Der Widerstandswert des Kodierwiderstands R_{C} ist spezifisch für eine Charakteristik der LED 2, so dass der spezifische Kodierwiderstand R_{C} eine Kodierung für die spezifische LED 2 darstellt. Insbesondere kann der Kodierwiderstand R_{C} die Lichtausbeute oder die Farbe der LED 2 bei einer Strom-Spannungs-Kennlinie kodieren. Durch Messung des Widerstandswertes des Kodierwiderstandes R_{C} kann so auf die Charakteristik der LED 2 geschlossen werden.

Die Leuchtdiodenanordnung 1 umfasst ein ESD-Schutzbauelement 3, das parallel zur LED 2 verschaltet ist. Das ESD-Schutzbauelement 3 dient vorzugsweise zum Schutz des Leuchtdiodenchips vor Überspannungen, insbesondere vor elektrostatischen Entladungen.

Die Leuchtdiodenanordnung 1 weist einen ersten und einen zweiten Anschluss 4, 5 auf, die als Kathode bzw. Anode ausgebildet sind. Bei einem sehr hohen Widerstand des Kodierwiderstand R_{C} können der Anoden- und Kathodenanschluss 4, 5 gemeinsam von der LED 2 und dem Kodierwiderstand R_{C} genutzt werden, weil ein sehr kleiner Leckstrom fließen würde. Die Messung kann dabei in die "reverse" Richtung erfolgen. Bei einem kleineren Widerstand des Kodierwiderstands R_{C} wird beispielsweise ein weiterer Anschluss integriert und die Verschaltung beispielsweise an der gestrichelt eingezeichneten Trennlinie 6 durchtrennt.

Figur 2 zeigt ein schematisches Schaltbild eines Kodierwiderstands R_{C}, der als Sternschaltung mehrerer Widerstände R₁, R₂, R₃ ausgebildet ist. Der Widerstandswert des Kodierwiderstands R_{C} kann mittels eines ersten und zweiten Kontakts 7, 8 bestimmt werden.

Der Kodierwiderstand R_{C} kann durch eine spezifische Vornahme bzw. Nicht-Vornahme von Unterbrechungen 12, 13, 14 der Zuleitungen 9, 10, 11 zu den jeweiligen Widerständen R₁, R₂, R₃ für eine spezifische LED kodiert werden. Auf diese Weise erfolgt die Kodierung digital. Bei drei Widerständen R₁, R₂, R3 mit unterschiedlichen Widerstandswerten können sich beispielsweise sieben mögliche Widerstandswerte für den Kodierwiderstand R_{C} ergeben. Insbesondere ergeben sich ein möglicher Widerstandswert bei der Unterbrechung keiner der drei Zuleitungen 9, 10, 11, ein weiterer möglicher Widerstandswert bei der Unterbrechung aller drei Zuleitungen 9, 10, 11, drei weitere mögliche Widerstandswerte für den Fall, dass nur eine Zuleitung 9, 10, 11 unterbrochen ist und drei weitere mögliche Widerstandswerte für den Fall, dass zwei von den drei Zuleitungen 9, 10, 11 unterbrochen sind. Damit stehen zur Kodierung sieben Binning-Klassen zur Verfügung.

Die Vornahme von Unterbrechungen 12, 13, 14 der Zuleitungen 9, 10, 11 erfolgt vorzugsweise nach der Messung der Charakteristik der LED 2, die durch den Kodierwiderstand R_{C} kodiert werden soll.

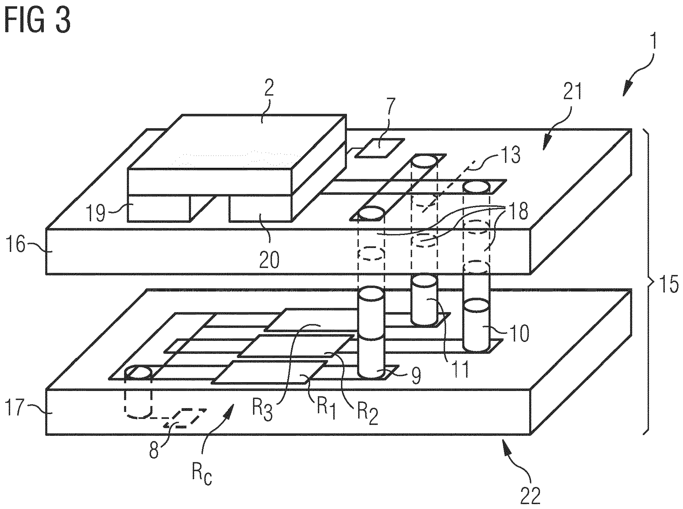

Figur 3 zeigt in einer schematischen perspektivischen Ansicht eine Leuchtdiodenanordnung 1, bei der eine LED 2 auf einem Träger 15 angeordnet ist. Die LED 2 ist mittels Anschlusskontakten 19, 20 elektrisch kontaktiert und am Träger 15 befestigt.

Vorliegend ist der Träger 15 in vielschichtiger LTCC-Technik ausgebildet. Aus Gründen der Darstellbarkeit ist nur die oberste Schicht 16 und eine weitere Schicht 17 abgebildet. Zwischen der obersten Schicht 16 und der weiteren Schicht 17 können ein oder mehrere weitere Schichten vorhanden sein. Zudem können auch unterhalb der weiteren Schicht 17 ein oder mehrere weitere Schichten vorhanden sein.

Die Leuchtdiodenanordnung 1 weist drei Widerstände R₁, R₂, R₃ auf, die zu einem Kodierwiderstand R_{C} verschaltet sind. Die Widerstände R₁, R₂, R₃ sind als Dünnschichtwiderstände ausgebildet. Die Widerstände R₁, R₂, R₃ sind im Träger 15 vergraben. Die Widerstände R₁, R₂, R3 sind durch Zuleitungen 9, 10, 12 mit der LED 2 verschaltet. Die Zuleitungen 9, 10, 12 sind abschnittsweise als Vias 18 ausgebildet und an der Oberseite 21 des Trägers 15 nach außen geführt. Via steht für "vertical interconnect access" und bezeichnet eine Durchkontaktierung.

Nach dem Vermessen der LED-Charakteristik wird der Kodierwiderstand R_{C} auf die LED 2 kodiert, indem die Zuleitungen 9, 10, 11 spezifisch unterbrochen, insbesondere durchtrennt, oder nicht unterbrochen werden. Die Zuleitungen 9, 10, 11 können beispielsweise mittels eines Lasers unterbrochen werden. Vorliegend ist angedeutet, dass zur Kodierung nur die zweite Zuleitung 10, die den zweiten Widerstand R₂ mit der LED 2 verbindet, mit einer Unterbrechung 13 versehen wird. Somit ergibt sich ein Gesamtwiderstand des Kodierwiderstands R_{C}, der die Charakteristik der LED 2 kodiert.

Der Gesamtwiderstand des Kodierwiderstands R_{C} kann mittels zweier Kontakte 7, 8 gemessen werden, um so die Charakteristik der LED 2 zu ermitteln. Die Kontakte 7, 8 sind auf der Oberseite 21 bzw. der Unterseite 22 des Trägers 15 angeordnet und mit dem Kodierwiderstands R_{C} elektrisch verbunden. Vorliegend wird die Unterseite 22 durch die von der LED 2 abgewandte Seite der weiteren Schicht 17 gebildet. Es können aber noch weitere Schichten unterhalb der weiteren Schicht 17 vorhanden sein, wobei die Unterseite 22 von der untersten dieser weiteren Schichten gebildet wird.

### Bezugszeichenliste

- 1: Leuchtdiodenanordnung
- 2: Leuchtdiode
- 3: ESD-Schutzbauelement
- 4: erster Anschluss
- 5: zweiter Anschluss
- 6: Trennlinie
- 7: erster Kontakt
- 8: zweiter Kontakt
- 9: erste Zuleitung
- 10: zweite Zuleitung
- 11: dritte Zuleitung
- 12: Unterbrechung der ersten Zuleitung
- 13: Unterbrechung der zweiten Zuleitung
- 14: Unterbrechung der dritten Zuleitung
- 15: Träger
- 16: oberste Schicht
- 17: weitere Schicht
- 18: Via
- 19: Anschlusskontakt
- 20: Anschlusskontakt
- 21: Oberseite
- 22: Unterseite

- R_{C}: Kodierwiderstand
- R₁: erster Widerstand
- R₂: zweiter Widerstand
- R₃: dritter Widerstand

## Patentansprüche

1. Leuchtdiodenanordnung, aufweisend eine Leuchtdiode (2) und einen Kodierwiderstand (R_{C}) zur Kodierung der Leuchtdiode (2), wobei der Kodierwiderstand (R_{C}) mehrere miteinander verschaltete Widerstände (R₁, R₂, R₃) aufweist,
aufweisend einen Träger (15) aufweisend eine oberste Schicht (16) und eine weitere Schicht (17),
wobei die Leuchtdiode (2) auf der obersten Schicht (16) angeordnet ist
**dadurch gekennzeichnet, dass**
ein oder mehrere der Widerstände (R₁, R₂, R₃) im Träger (15) vergraben sind, aufweisend ein oder mehrere Zuleitungen (9, 10, 11), die mit den im Träger (15) vergrabenen Widerständen (R₁, R₂, R₃) verbunden sind, wobei die Zuleitungen (9, 10, 11) jeweils einen ersten Abschnitt aufweisen, der auf der obersten Schicht (16) seitlich von der Leuchtdiode (2) angeordnet ist, und jeweils einen zweiten Abschnitt aufweisen, der als Via (18) ausgebildet ist, wobei der Kodierwiderstand (R_{C}) zur Kodierung durch Vornahme oder Nicht-Vornahme einer Unterbrechung der jeweiligen ersten Abschnitte der Zuleitungen (12, 13, 14) ausgebildet ist.

2. Leuchtdiodenanordnung nach Anspruch 1, wobei der Kodierwiderstand (R_{C}) als Sternschaltung ausgebildet ist.

3. Leuchtdiodenanordnung nach einem der Ansprüche 1 oder 2, wobei die Kodierung durch Lasertrimmen vornehmbar ist.

4. Leuchtdiodenanordnung nach einem der Ansprüche 1 bis 3, wobei der Kodierwiderstand (R_{C}) wenigstens einen Widerstand (R₁, R₂, R₃) aufweist, der als Dünnschicht- oder Dickschichtwiderstand ausgebildet ist.

5. Leuchtdiodenanordnung nach einem der Ansprüche 1 bis 4, bei der erste Abschnitt der Zuleitungen (9, 10, 11) jeweils mit der Leuchtdiode (2) elektrisch verbunden ist.

6. Leuchtdiodenanordnung nach einem der Ansprüche 1 bis 5, aufweisend einen ersten Anschluss (7) und einen zweiten Anschluss (8) zur Messung des Widerstandswerts des Kodierwiderstands (R_{C}), wobei wenigstens einer der Anschlüsse (7, 8) auch als Anschluss der Leuchtdiode (2) ausgebildet ist.

7. Leuchtdiodenanordnung nach einem der Ansprüche 1 bis 6, wobei der Kodierwiderstand (R_{C}) wenigstens einen Widerstand (R₁, R₂, R₃) aufweist, der zur Messung der Temperatur der LED (2) ausgebildet ist.

8. Leuchtdiodenanordnung nach einem der Ansprüche 1 bis 7, die einen Träger (15) aufweist, der ein keramisches Material oder ein organisches Material aufweist.

9. Leuchtdiodenanordnung nach einem der Ansprüche 1 bis 8, die einen Träger (15) aufweist, der in Vielschichtbauweise ausgebildet ist.

10. Modul aufweisend mehrere Leuchtdiodenanordnungen (1) nach einem der Ansprüche 1 bis 9, die auf einem weiteren Träger angeordnet sind.

11. Verfahren zur Kodierung eines Kodierwiderstands (R_{C}) einer Leuchtdiodenanordnung (1), aufweisend die Schritte A) Bereitstellen einer Leuchtdiodenanordnung (1) gemäß einem der Ansprüche 1 bis 9,
C) Ermittlung einer Charakteristik der Leuchtdiode (2),
D) Kodierung des Kodierwiderstandes (R_{C}) abhängig von der ermittelten Charakteristik durch Vornahme oder Nicht-Vornahme einer Unterbrechung des jeweiligen ersten Abschnitts der Zuleitungen (12, 13, 14).

## Claims

1. Light-emitting diode arrangement, comprising a light-emitting diode (2) and a coding resistor (R_{C}) for coding the light-emitting diode (2), wherein the coding resistor (R_{C}) comprises a plurality of interconnected resistors (R₁, R₂, R₃), comprising a carrier (15) comprising an uppermost layer (16) and a further layer (17),
wherein the light-emitting diode (2) is arranged on the uppermost layer (16),
**characterized in that**
one or more of the resistors (R₁, R₂, R₃) are buried in the carrier (15),
comprising one or more supply lines (9, 10, 11) connected to the resistors (R₁, R₂, R₃) buried in the carrier (15), wherein the supply lines (9, 10, 11) each have a first portion that is arranged on the uppermost layer (16) laterally of the light-emitting diode (2) and each have a second portion that is embodied in the form of a via (18), wherein the coding resistor (R_{C}) is implemented for coding by the implementation of an interruption or the non-implementation of an interruption of the respective first portions of the supply lines (12, 13, 14).

2. Light-emitting diode arrangement according to Claim 1, wherein the coding resistor (R_{C}) is embodied in the form of a star connection.

3. Light-emitting diode arrangement according to either of Claims 1 and 2, wherein the coding is implementable by laser trimming.

4. Light-emitting diode arrangement according to any of Claims 1 to 3, wherein the coding resistor (R_{C}) comprises at least one resistor (R₁, R₂, R₃) which is embodied as a thin-film or thick-film resistor.

5. Light-emitting diode arrangement according to any of Claims 1 to 4, in which the first portion of the supply lines (9, 10, 11) is electrically connected in each case to the light-emitting diode (2).

6. Light-emitting diode arrangement according to any of Claims 1 to 5, comprising a first connection (7) and a second connection (8) for measuring the resistance value of the coding resistor (R_{C}), wherein at least one of the connections (7, 8) is also embodied as a connection of the light-emitting diode (2).

7. Light-emitting diode arrangement according to any of Claims 1 to 6, wherein the coding resistor (R_{C}) comprises at least one resistor (R₁, R₂, R₃) which is designed for measuring the temperature of the LED (2).

8. Light-emitting diode arrangement according to any of Claims 1 to 7, which comprises a carrier (15) comprising a ceramic material or an organic material.

9. Light-emitting diode arrangement according to any of Claims 1 to 8, which comprises a carrier (15) of multilayer design.

10. Module comprising a plurality of light-emitting diode arrangements (1) according to any of Claims 1 to 9, which are arranged on a further carrier.

11. Method for coding a coding resistor (R_{C}) of a light-emitting diode arrangement (1), including the steps of:
A) providing a light-emitting diode arrangement (1) according to any of Claims 1 to 9,
C) determining a characteristic of the light-emitting diode (2),
D) coding the coding resistor (R_{C}) depending on the determined characteristic by the implementation or the non-implementation of an interruption of the respective first portion of the supply lines (12, 13, 14).

## Revendications

1. Agencement de diode électroluminescente, présentant une diode électroluminescente (2) et une résistance de codage (R_{C}) servant à coder la diode électroluminescente (2), la résistance de codage (R_{C}) présentant plusieurs résistances (R1, R2, R3) interconnectées,
présentant un substrat (15) qui présente une couche supérieure (16) et une couche supplémentaire (17),
la diode électroluminescente (2) étant disposée sur la couche supérieure (16),
**caractérisé en ce qu'**une ou plusieurs résistances (R₁, R₂, R₃) sont noyées dans le substrat (15),
présentant un ou plusieurs conducteur d'alimentation (9, 10, 11) qui sont reliés aux résistances (R₁, R₂, R₃) noyées dans le substrat (15), les conducteurs d'alimentation (9, 10, 11) présentant respectivement une première partie qui est disposée sur la couche supérieure (16) latéralement par rapport à la diode électroluminescente (2), et présentant respectivement une deuxième partie qui est réalisée sous la forme d'un trou d'interconnexion (18), la résistance de codage (R_{C}) étant réalisée pour le codage par la réalisation ou la non réalisation d'une rupture des premières parties respectives des conducteurs d'alimentation (12, 13, 14).

2. Agencement de diode électroluminescente selon la revendication 1, dans lequel la résistance de codage (R_{C}) est réalisée sous la forme d'un montage en étoile.

3. Agencement de diode électroluminescente selon l'une quelconque des revendications 1 ou 2, dans lequel le codage peut être effectué par dressage au laser.

4. Agencement de diode électroluminescente selon l'une quelconque des revendications 1 à 3, dans lequel la résistance de codage (R_{C}) présente au moins une résistance (R₁, R₂, R₃) qui est réalisée sous la forme d'une résistance en couche mince ou en couche épaisse.

5. Agencement de diode électroluminescente selon l'une quelconque des revendications 1 à 4, dans lequel la première partie des conducteurs d'alimentation (9, 10, 11) est respectivement reliée électriquement à la diode électroluminescente (2).

6. Agencement de diode électroluminescente selon l'une quelconque des revendications 1 à 5, présentant une première borne (7) et une deuxième borne (8) servant à mesurer la valeur de résistance de la résistance de codage (R_{C}), au moins l'une des bornes (7, 8) étant également réalisée sous la forme d'une borne de la diode électroluminescente (2).

7. Agencement de diode électroluminescente selon l'une quelconque des revendications 1 à 6, dans lequel la résistance de codage (R_{C}) présente au moins une résistance (R₁, R₂, R₃) qui est réalisée pour mesurer la température de la LED (2).

8. Agencement de diode électroluminescente selon l'une quelconque des revendications 1 à 7, qui présente un substrat (15) qui présente un matériau céramique ou un matériau organique.

9. Agencement de diode électroluminescente selon l'une quelconque des revendications 1 à 8, qui présente un substrat (15) qui est réalisé en conception multicouche.

10. Module présentant plusieurs agencements de diode électroluminescente (1) selon l'une quelconque des revendications 1 à 9 qui sont disposés sur un substrat supplémentaire.

11. Procédé de codage d'une résistance de codage (R_{C}) d'un agencement de diode électroluminescente (1), présentant les étapes consistant à
A) fournir un agencement de diode électroluminescente (1) selon l'une quelconque des revendications 1 à 9,
C) établir une caractéristique de la diode électroluminescente (2),
D) coder la résistance de codage (R_{C}) en fonction de la caractéristique établie par la réalisation ou la non réalisation d'une rupture de la première partie respective des conducteurs d'alimentation (12, 13, 14).
